# EUROPÄISCHE PATENTSCHRIFT

(11) **EP 2 448 000 B1**
(45) Veröffentlichungstag und Bekanntmachung des Hinweises auf die Patenterteilung: **16.07.2014**
(21) Anmeldenummer: 11008218.7
(22) Anmeldetag: 12.10.2011
(51) Int. Cl.: H01L 31/02, G01R 31/40

(54) **Photovoltaikanlage und Verfahren dazu**
Photovoltaic device and method to operate it
Installation photovoltaïque et son procédé d'opération

(30) Priorität: 26.10.2010 DE 202010014744 U
(43) Veröffentlichungstag der Anmeldung: 02.05.2012
(73) Patentinhaber: Diehl AKO Stiftung & Co. KG, 88239 Wangen im Allgäu (DE)
(72) Erfinder: Frehner, Klaus, 88239 Wangen (DE)
(74) Vertreter: Diehl Patentabteilung

(56) Entgegenhaltungen:
- DE-A1-102009 029 934
- DE-U1-202005 020 161
- DE-U1-202007 011 806
- US-A1- 2006 162 772
- US-A1- 2009 242 011
- VENKATACHALAM L ET AL: "Wireless Sensor Networks to Characterize Photovoltaic Panels in Harsh Environmental Conditions", SIGNAL PROCESSING AND COMMUNICATIONS, 2007. ICSPC 2007. IEEE INTERNATIONAL CONFERENCE ON, IEEE, PISCATAWAY, NJ, USA, 24. November 2007 (2007-11-24), Seiten 788-791, XP031380641, ISBN: 978-1-4244-1235-8

## Beschreibung

Die vorliegende Erfindung betrifft eine Photovoltaikanlage mit einer Mehrzahl von elektrischen oder elektronischen Komponenten nach dem Oberbegriff des Anspruches 1.

Photovoltaikanlagen dienen der Einspeisung von elektrischem Strom in ein elektrisches Netz oder einen Verbraucher. Zu diesem Zweck können sie einen oder mehrere Photovoltaikgeneratoren aufweisen, welche jeweils aus mehreren Solarmodulen mit jeweils wenigstens einer Solarzelle bestehen. Die Solarmodule sind dabei zu so genannten Strings in Reihe zusammengeschaltet. Die photovoltaisch erzeugte Gleichspannung des/der Strings wird einem oder mehreren Wechselrichtern zugeführt, der/die diese in eine geregelte, standardisierte, ein-oder mehrphasige Wechselspannung umwandelt/umwandeln, um sie in ein Stromnetz einzuspeisen oder einem Verbraucher zur Verfügung zu stellen.

Insbesondere bei sehr großen Photovoltaikanlagen besteht das Problem, dass zu Überwachungs-, Wartungs- und Reparaturzwecken die einzelnen Komponenten der Photovoltaikanlage innerhalb der Anlage lokalisiert werden müssen.

In diesem Zusammenhang schlägt die DE 10 2006 034 223 B4 der Anmelderin eine Photovoltaikanlage vor, bei welcher jedes Solarmodul eines Strings mit einer Messvorrichtung zum Erfassen von Betriebsdaten versehen ist, wobei diese Messvorrichtungen mit einer zentralen Steuerung im Wechselrichter verbunden sind und dieser neben den Betriebsdaten auch Informationen darüber ausgibt, welches Solarmodul innerhalb des Strings als fehlerhaft analysiert worden ist.

Der Wartungsaufwand kann so im Fall eines fehlerhaften Solarmoduls reduziert werden, da das Analyseergebnis dem Betreiber der Photovoltaikanlage auch konkret das fehlerhafte Solarmodul anzeigt. Bei großen Photovoltaikanlagen mit zahlreichen Photovoltaikgeneratoren muss der Betreiber beim Überwachen aber dennoch manuell den fehlerhaften String in der Anlage lokalisieren.

Die DE 20 2007 011 806 U1 offenbart eine Photovoltaikanlage mit einer Mehrzahl von Solarelementen, welche jeweils einen Identchip mit einem individuellen Identcode aufweisen und über ein leitungsgebundenes Bussystem mit einem Zentralprozessor verbunden sind. Der Zentralprozessor ist ausgebildet, um die Identcodes aller installierten Solarelemente in regelmäßigen Zeitintervallen auszulesen und mit den gespeicherten Identcodes zu vergleichen. Fehlt ein gespeicherter Identcode bei den ausgelesenen Identcodes, so kann auf ein Fehlen des entsprechenden Solarelements (zum Beispiel wegen Diebstahls) geschlossen und dementsprechend eine Alarmeinheit an dem Zentralprozessor aktiviert werden, um den Betreiber der Photovoltaikanlage zu alarmieren.

Die DE 102 22 621 A1 beschreibt ein Verfahren und eine Schaltungsanordnung zur Steuerung von Photovoltaikanlagen, bei welchen jedem Solarmodul eines Strings eine Steuereinrichtung parallel geschaltet wird, die über eine Kommunikations-Schnittstelle mit einem Datenbus verbunden ist.

In der DE 10 2009 029 934 A1 ist eine Photovoltaikanlage offenbart, in welcher die Solarmodule in einem selbstorganisierenden Kommunikationsnetzwerk miteinander verbunden sind, wobei dieses Netzwerk unabhängig von den Stromverbindungsleitungen für die photovoltaisch erzeugte Leistung ist und auch eine andere Topologie aufweist. Über dieses Kommunikationsnetzwerk können durch Messeinrichtungen erfasste Leistungskenngrößen der Solarmodule an eine Kontrolleinrichtung übertragen werden.

Während es zu Überwachungs- und Wartungszwecken somit bekannt ist, die Betriebsdaten und Steuerdaten zwischen den Solarmodulen, Wechselrichtern und zentralen Steuerungen über ein Kommunikationsnetz auszutauschen, besteht weiterhin Bedarf an einer Vereinfachung beim Auffinden konkreter Komponenten in einer großen Photovoltaikanlage, um eine Reparatur, eine Wartung, ein Update, etc. vor Ort durchführen zu können.

Es ist daher eine Aufgabe der Erfindung, eine verbesserte Photovoltaikanlage zu schaffen, welche ein leichteres Auffinden einzelner Komponenten(gruppen) in der Anlage ermöglicht.

Diese Aufgabe wird gelöst durch eine Photovoltaikanlage mit den Merkmalen des Anspruches 1. Vorteilhafte Ausgestaltungen und Weiterbildungen der Erfindung sind Gegenstand der abhängigen Ansprüche.

Die Photovoltaikanlage weist eine Mehrzahl von elektrischen oder elektronischen Komponenten auf, die an bestimmten Positionen angeordnet sind, wobei die Komponenten einzeln oder gruppenweise mit wenigstens einer Kommunikations-Schnittstelle versehen sind, welche mit einem Kommunikationsnetz der Photovoltaikanlage in Kommunikationsverbindung steht. Dabei sind die Komponenten einzeln oder gruppenweise mit wenigstens einer Signalvorrichtung versehen, die über eine Kommunikations-Schnittstelle mit dem Kommunikationsnetz der Photovoltaikanlage in Kommunikationsverbindung steht. Ferner weist die Photovoltaikanlage wenigstens eine Eingabevorrichtung zum Eingeben eines Gerätecodes einer einzelnen Komponente oder einer Gruppe der Mehrzahl von Komponenten auf, welche mit einer Kommunikations-Schnittstelle zur Kommunikationsverbindung mit dem Kommunikationsnetz der Photovoltaikanlage und Aussenden des eingegebenen Gerätecodes in das Kommunikationsnetz versehen ist. Außerdem sind die Signalvorrichtungen derart ausgebildet, dass sie beim Empfang des Gerätecodes der jeweiligen Komponente bzw. der jeweiligen Gruppe von Komponenten über das Kommunikationsnetz aktiviert werden.

Die relevanten Komponenten der Photovoltaikanlage sind in ein Kommunikationsnetz der Anlage eingebunden. Bei Bedarf kann ein Betreiber der Photovoltaikanlage oder ein Monteur über eine Eingabevorrichtung einen Gerätecode in dieses Kommunikationsnetz schicken, welcher zu einer einzelnen Komponente oder einer Gruppe von Komponenten gehört, die von dem Betreiber bzw. Monteur zum Beispiel zu Wartungs- oder Reparaturzwecken gesucht wird. Beim Empfang dieses Gerätecodes über das Kommunikationsnetz wird die wenigstens eine Signalvorrichtung der jeweiligen Komponente / Gruppe von Komponenten aktiviert. Anhand der so aktivierten Signalvorrichtung kann der Betreiber bzw. Monteur die von ihm gesuchte Komponente / Gruppe von Komponenten selbst in einer sehr großen Photovoltaikanlage mit zahlreichen Komponenten einfach physisch auffinden. Es entfällt zum Beispiel ein aufwändiges Lesen der Typenschilder der Komponenten beim Durchsuchen der Anlage oder die Verwendung eines Ortsplanes, auf dem die Komponenten verzeichnet sind, es genügt ein einfaches Beobachten der Photovoltaikanlage. Bei korrekter Eingabe des Gerätecodes ist auch eine eindeutige Kennzeichnung der Komponente / Gruppe von Komponenten gewährleistet.

Die Erfindung ist besonders vorteilhaft bei großen Photovoltaikanlagen mit zahlreichen Komponenten einsetzbar. Vorteile und Anwendungsmöglichkeiten ergeben sich aber natürlich auch bei kleineren Anlagen.

Bei den "elektrischen oder elektronischen Komponenten" der Photovoltaikanlage handelt es sich insbesondere um Solarmodule und Wechselrichter der Anlage, ohne dass die Erfindung auf diese Komponenten beschränkt sein soll. Eine "Gruppe von Komponenten" enthält wenigstens zwei solcher Komponenten, kann aber auch eine größere Anzahl von Komponenten enthalten. Beispielsweise kann eine Gruppe von Komponenten durch einen String mit mehreren Solarmodulen und ggf. einem zugehörigen Wechselrichter gebildet werden.

Eine "Kommunikationsverbindung" bzw. ein "Kommunikationsnetz" können im Sinne dieser Verbindung vorzugsweise drahtlos (z.B. per Funk) oder drahtgebunden konfiguriert sein. Vorzugsweise handelt es sich bei dem Kommunikationsnetz um ein drahtloses oder drahtgebundenes Datenbussystem.

Unter einem "Gerätecode" soll eine eindeutige Gerätekennzeichnung der jeweiligen Komponente / Gruppe von Komponenten verstanden werden. Der Gerätecode kann beispielsweise einer Seriennummer der Komponente entsprechen, die ggf. um weitere Angaben ergänzt ist.

Die Signalvorrichtungen stehen "über eine Kommunikations-Schnittstelle mit dem Kommunikationsnetz der Photovoltaikanlage in Kommunikationsverbindung".

Diese Kommunikations-Schnittstelle kann wahlweise an der Signalvorrichtung selbst vorgesehen sein oder an einer anderen Vorrichtung vorgesehen sein, mit welcher die Signalvorrichtung verbunden / gekoppelt ist.

In einer vorteilhaften Ausgestaltung der Erfindung weisen die Komponenten jeweils eine Steuereinrichtung auf und sind die Kommunikations-Schnittstellen an diesen Steuereinrichtungen vorgesehen.

In einer weiteren vorteilhaften Ausgestaltung der Erfindung weisen die Komponenten jeweils eine Steuereinrichtung auf und sind die Signalvorrichtungen mit diesen Steuereinrichtungen verbunden, wobei die Steuereinrichtungen ausgebildet sind, um beim Empfang des Gerätecodes der jeweiligen Komponente bzw. der jeweiligen Gruppe von Komponenten über das Kommunikationsnetz die wenigstens eine Signalvorrichtung zu aktivieren.

Diese Steuereinrichtungen der vorgenannten Ausgestaltungen können darüber hinaus auch ausgebildet sein, um Betriebsdaten der jeweiligen Komponenten / Gruppen von Komponenten in das Kommunikationsnetz zu senden und/oder Steuerdaten für die jeweiligen Komponenten / Gruppen von Komponenten aus dem Kommunikationsnetz zu empfangen.

In einer vorteilhaften Ausgestaltung der Erfindung sind die Signalvorrichtungen jeweils mit einer. Energiespeichervorrichtung versehen, welche bei einem Ausfall der jeweiligen Komponente(n) den Datenempfang über das Kommunikationsnetz und den Betrieb der Signalvorrichtung(en) noch zumindest für eine gewisse Zeitdauer ermöglicht. Diese Eriergiespeichervorrichtungen sind vorzugsweise in die jeweiligen Steuereinrichtungen integriert. Durch diese Energiespeichervorrichtung besteht vorteilhafterweise die Möglichkeit, selbst defekte Komponente noch einige Zeit nach deren Ausfall auffinden zu können.

Die wenigstens eine Signalvorrichtung einer einzelnen oder einer Gruppe von Komponenten ist vorzugsweise ausgewählt aus akustischen Signalvorrichtungen, optischen Signalvorrichtung und Kombinationen davon. Die Komponenten / Gruppen von Komponenten sind bevorzugt mit einer akustischen und einer optischen Signalvorrichtung ausgestattet. Die akustische bzw. optische Signalstärke ist vorzugsweise fest vorgegeben und kann vom Anwender nicht abgeändert werden.

Die wenigstens eine Eingabevorrichtung ist vorzugsweise ausgewählt aus mobilen Eingabevorrichtungen, mit einer Komponente verbundenen Eingabevorrichtungen und mit einer zentralen Steuereinrichtung der Photovoltaikanlage verbundenen Eingabevorrichtungen.

In einer vorteilhaften Ausgestaltung der Erfindung kann das Kommunikationsnetz der Photovoltaikanlage unabhängig von den Stromverbindungsleitungen für die photovoltaisch erzeugte Leistung sein.

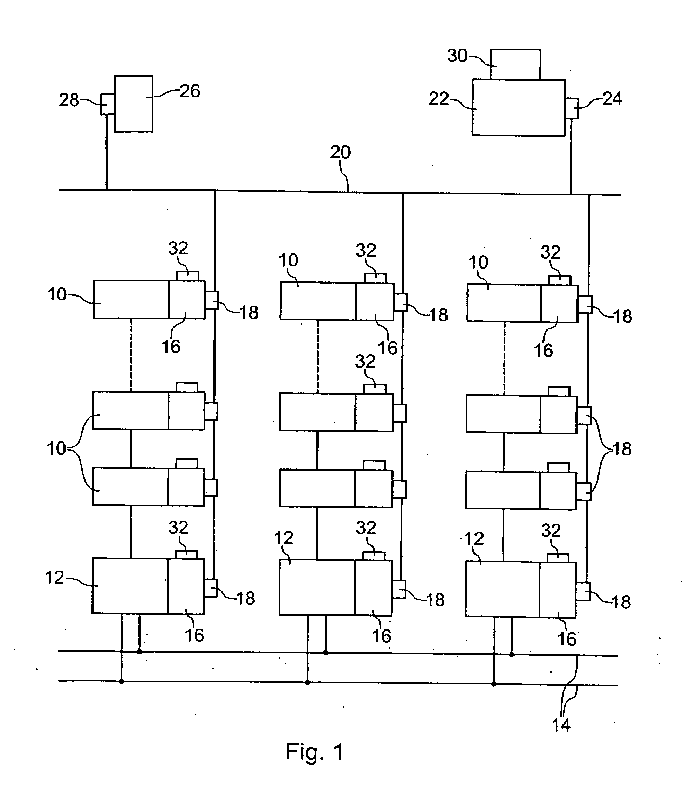

Obige sowie weitere Merkmale und Vorteile der Erfindung werden aus der nachfolgenden Beschreibung eines bevorzugten, nicht-einschränkenden Ausführungsbeispiels unter Bezugnahme auf die beiliegende Zeichnung besser verständlich. Darin zeigt die einzige Figur 1 eine stark vereinfachte Darstellung des Aufbaus einer Photovoltaikanlage gemäß einem bevorzugten Ausführungsbeispiel der vorliegenden Erfindung.

In Figur 1 ist ein Ausschnitt einer Photovoltaikanlage gezeigt, welcher drei Strings von in Reihe geschalteten Solarmodulen 10 mit jeweils wenigstens einer Solarzelle zeigt. Die von diesen Solarmodulen 10 photovoltaisch erzeugte Gleichspannung wird jeweils einem Wechselrichter 12 zugeführt, der diese in eine geregelte Wechselspannung umwandelt, um sie in ein Stromnetz 14 einzuspeisen oder einem Verbraucher zur Verfügung zu stellen. Wahlweise können auch mehrere Strings von Solarmodulen 10 mit einem gemeinsamen Wechselrichter 12 verbunden werden.

Die Solarmodule 10 und die Wechselrichter 12 bilden die elektrischen oder elektronischen Komponenten der Erfindung. Im Ausführungsbeispiel von Figur 1 ist jede dieser Komponenten 10, 12 mit einer Steuereinrichtung 16 versehen, welche die aktuellen Betriebsdaten der jeweiligen Komponente 10, 12 (z.B. über geeignete Messvorrichtungen) erfasst, ggf. die jeweilige Komponente ansteuert und mit einem Kommunikationsnetz 20 der Photovoltaikanlage in Kommunikationsverbindung steht. Zu diesem Zweck sind die Steuereinrichtungen 16 der Komponenten 10, 12 jeweils mit einer entsprechenden Kommunikations-Schnittstelle 18 versehen.

Während in dem Ausführungsbeispiel von Figur 1 die Steuereinrichtungen 16 aller Komponenten 10, 12 mit dem Kommunikationsnetz 20 der Photovoltaikanlage in Kommunikationsverbindung stehen, kann dies alternativ auch nur für einen Teil der Komponenten, zum Beispiel nur für die Wechselrichter 12 gelten. Auf diese Weise werden die Komponenten 10, 12 kommunikationstechnisch zu Gruppen von Komponenten zusammengefasst.

Darüber hinaus weist die Photovoltaikanlage wenigstens eine zentrale Steuereinrichtung 22 auf, welche ebenfalls über eine Kommunikations-Schnittstelle 24 verfügt und über diese mit dem Kommunikationsnetz 20 in Kommunikationsverbindung steht. Diese zentrale Steuereinrichtung 22 kann über das Kommunikationsnetz 20 zum Beispiel die Betriebsdaten von den Solarmodulen 10 und Wechselrichtern 12 empfangen und auswerten und/oder Steuerdaten an diese Komponenten 10, 12 senden.

Wie in Figur 1 veranschaulicht, ist das Kommunikationsnetz 20 unabhängig von den Stromverbindungsleitungen zwischen den Solarmodulen 10, den Wechselrichtern 12 und dem Stromnetz 14 für die photovoltaisch erzeugte Leistung konzipiert. Das Kommunikationsnetz kann wahlweise drahtgebunden oder drahtlos (z.B. Funk) aufgebaut sein.

Ferner ist in der Photovoltaikanlage wenigstens eine Eingabevorrichtung vorgesehen. Im Ausführungsbeispiel von Figur 1 sind beispielhaft eine mobile Eingabevorrichtung 26 und eine mit der zentralen Steuereinrichtung 22 verbundene / gekoppelte Eingabevorrichtung 30 vorhanden. Während die mobile Eingabevorrichtung 26 über eine eigene Kommunikations-Schnittstelle 28 zur Herstellung einer Kommunikationsverbindung mit dem Kommunikationsnetz 20 der Photovoltaikanlage verfügt, ist die Eingabevorrichtung 30 über die Kommunikations-Schnittstelle 24 der zentralen Steuereinrichtung 22 an das Kommunikationsnetz 20 angeschlossen. Während die zentrale Steuervorrichtung 22 mit der Eingabevorrichtung 30 üblicherweise an einem bestimmten Ort fest installiert ist, kann die mobile Eingabevorrichtung 26 an beliebigen oder nahezu beliebigen oder vielfältigen Stellen über ihre Kommunikations-Schnittstelle 28 an das Kommunikationsnetz 20 der Photovoltaikanlage angekoppelt werden.

Mit Hilfe der verfügbaren Eingabevorrichtungen 26, 30 kann ein Betreiber, Monteur, usw. der Photovoltaikanlage bei Bedarf einen Gerätecode einer bestimmten Komponente oder Gruppe von Komponenten in das Kommunikationsnetz 20 der Photovoltaikanlage eingeben / senden. Der so eingegebene Gerätecode wird über die Kommunikationsstellen 18 der Steuereinrichtungen 16 aller Komponenten / Gruppen von Komponenten empfangen / gelesen.

Erkennt eine Steuereinrichtung 16, dass der empfangene Gerätecode zu ihrer Komponente / Gruppe von Komponenten gehört, so wird ein Signal für den Betreiber / Monteur ausgegeben, damit dieser die gesuchte Komponente / Gruppe von Komponenten zum Beispiel zu Reparatur- oder Wartungszwecken einfach durch Beobachten der Photovoltaikanlage leicht auffinden kann.

Zu diesem Zweck weisen die Komponenten 10, 12 jeweils wenigstens eine akustische und/oder optische Signalvorrichtung 32 auf, welche mit der Steuereinrichtung 16 verbunden ist. Alternativ können die Komponenten 10, 12 auch nur gruppenweise mit solchen Signalvorrichtungen 32 ausgestattet sein.

Die durch den Gerätecode aktivierte Signalvorrichtung 32 gibt zum Beispiel ein optisches Blinksignal und/oder einen akustischen Buzzerton aus. Die Leistungsstärke des ausgegebenen Signals wird bevorzugt herstellerseitig vorgegeben und kann nicht verändert, insbesondere nicht vermindert werden.

Um den oben beschriebenen Prozess des leichten Auffindens einer Komponente / Gruppe von Komponenten in einer großen Photovoltaikanlage auch dann noch zu gewährleisten, wenn die gesuchte Komponente ausgefallen ist, sind die Komponenten vorzugsweise jeweils mit einer Energiespeichervorrichtung ausgestattet. Diese Energiespeichervorrichtungen sind beispielsweise in die Steuereinrichtungen 16 der Komponenten 10, 12 integriert und werden durch die photovoltaisch erzeugte Leistung der Solarmodule 10 aufgeladen.

Mit Hilfe dieser Energiespeichervorrichtungen können die Steuereinrichtungen 16 und die Signalvorrichtungen 32 der Komponenten 10, 12 auch bei einem Ausfall oder einer Fehlfunktion noch eine gewisse Zeitdauer ein Lesen des Gerätecodes und ein Aktivieren der Signalvorrichtung 32 ermöglichen.

### BEZUGSZIFFERNLISTE

- 10: Solarmodul
- 12: Wechselrichter
- 14: Stromnetz
- 16: Steuereinrichtung
- 18: Kommunikations-Schnittstelle von 16
- 20: Kommunikationsnetz
- 22: zentrale Steuereinrichtung
- 24: Kommunikations-Schnittstelle von 22
- 26: Eingabevorrichtung
- 28: Kommunikations-Schnittstelle von 26
- 30: Eingabevorrichtung
- 32: Signalvorrichtung

## Patentansprüche

1. Photovoltaikanlage, mit einer Mehrzahl von elektrischen oder elektronischen Komponenten (10, 12), die an bestimmten Positionen angeordnet sind, wobei die Komponenten (10, 12) einzeln oder gruppenweise mit wenigstens einer Kommunikations-Schnittstelle (18) versehen sind, welche mit einem Kommunikationsnetz (20) der Photovoltaikanlage in Kommunikationsverbindung steht,
**dadurch gekennzeichnet, dass**
die Komponenten (10, 12) einzeln oder gruppenweise jeweils wenigstens eine Signalvorrichtung (32) aufweisen, die über eine Kommunikations-Schnittstelle (18) mit dem Kommunikationsnetz (20) der Photovoltaikanlage in Kommunikationsverbindung steht;
die Photovoltaikanlage wenigstens eine Eingabevorrichtung (26, 30) zum Eingeben eines Gerätecodes einer gesuchten einzelnen Komponente oder einer gesuchten Gruppe der Mehrzahl von Komponenten (10, 12) aufweist, welche mit einer Kommunikations-Schnittstelle (28, 24) zur Kommunikationsverbindung mit dem Kommunikationsnetz (20) der Photovoltaikanlage und Aussenden des eingegebenen Gerätecodes in das Kommunikationsnetz (20) versehen ist; und
die Signalvorrichtungen (32) jeweils ausgebildet sind, um beim Empfang des Gerätecodes der jeweiligen Komponente bzw. der jeweiligen Gruppe von Komponenten über das Kommunikationsnetz (20) aktiviert zu werden, um die gesuchte Komponente oder Gruppe von Komponenten (10, 12) durch Beobachten der Photovoltaikanlage auffindbar zu machen.

2. Photovoltaikanlage nach Anspruch 1,
**dadurch gekennzeichnet, dass**
die Komponenten (10, 12) jeweils eine Steuereinrichtung (16) aufweisen; und
die Kommunikations-Schnittstellen (18) an diesen Steuereinrichtungen (16) vorgesehen sind.

3. Photovoltaikanlage nach Anspruch 1 oder 2,
**dadurch gekennzeichnet, dass**
die Komponenten (10, 12) jeweils eine Steuereinrichtung (16) aufweisen; und
die Signalvorrichtungen (16) mit diesen Steuereinrichtungen (16) verbunden sind, wobei die Steuereinrichtungen (16) ausgebildet sind, um beim Empfang des Gerätecodes der jeweiligen Komponente bzw. der jeweiligen Gruppe von Komponenten über das Kommunikationsnetz (20) die wenigstens eine Signalvorrichtung (32) zu aktivieren.

4. Photovoltaikanlage nach einem der vorhergehenden Ansprüche,
**dadurch gekennzeichnet, dass**
die Signalvorrichtungen (32) jeweils mit einer Energiespeichervorrichtung versehen sind, welche bei einem Ausfall der jeweiligen Komponente(n) den Datenempfang über das Kommunikationsnetz (20) und den Betrieb der Signalvorrichtung(en) (32) noch zumindest für eine gewisse Zeitdauer ermöglicht.

5. Photovoltaikanlage nach Anspruch 4,
**dadurch gekennzeichnet, dass**
die Energiespeichervorrichtungen in die jeweiligen Steuereinrichtungen (16) integriert sind.

6. Photovoltaikanlage nach einem der vorhergehenden Ansprüche,
**dadurch gekennzeichnet, dass**
die wenigstens eine Signalvorrichtung (32) einer einzelnen oder einer Gruppe von Komponenten (10, 12) ausgewählt ist aus akustischen Signalvorrichtungen, optischen Signalvorrichtung und Kombinationen davon.

7. Photovoltaikanlage nach einem der vorhergehenden Ansprüche,
**dadurch gekennzeichnet, dass**
die wenigstens eine Eingabevorrichtung (26, 30) ausgewählt ist aus mobilen Eingabevorrichtungen, mit einer Komponente (10, 12) verbundenen Eingabevorrichtungen und mit einer zentralen Steuereinrichtung (22) der Photovoltaikanlage verbundenen Eingabevorrichtungen.

8. Photovoltaikanlage nach einem der vorhergehenden Ansprüche,
**dadurch gekennzeichnet, dass**
das Kommunikationsnetz (20) der Photovoltaikanlage unabhängig von den Stromverbindungsleitungen für die photovoltaisch erzeugte Leistung ist.

9. Verfahren zum Betreiben einer Photovoltaikanlage, die eine Mehrzahl von elektrischen oder elektronischen Komponenten (10, 12) an bestimmten Positionen aufweist, die einzeln oder gruppenweise mit wenigstens einer Kommunikations-Schnittstelle (18) versehen sind, welche mit einem Kommunikationsnetz (20) der Photovoltaikanlage in Kommunikationsverbindung steht,
bei welchem zum Auffinden einer gesuchten Komponente oder Gruppe von Komponenten (10, 12:
ein Gerätecode der gesuchten Komponente oder Gruppe von Komponenten über eine Eingabevorrichtung (26, 30) in das Kommunikationsnetz (20) der Photovoltaikanlage ausgesendet wird; und
eine Signalvorrichtung (32) an der Komponente oder Gruppe von Komponenten, die dem eingegebenen Gerätecode entspricht, beim Empfangen des eingegebenen Gerätecodes über das Kommunikationsnetz (20) der Photovoltaikanlage aktiviert wird.

## Claims

1. Photovoltaic installation having a plurality of electrical or electronic components (10, 12) arranged at particular positions, the components (10, 12) being provided, individually or in groups, with at least one communication interface (18) which is communicatively connected to a communication network (20) of the photovoltaic installation,
**characterized in that**
the components (10, 12) each have, individually or in groups, at least one signalling apparatus (32) which is communicatively connected to the communication network (20) of the photovoltaic installation via a communication interface (18); the photovoltaic installation has at least one input apparatus (26, 30) for inputting a device code of a sought individual component or a sought group of the plurality of components (10, 12), which input apparatus is provided with a communication interface (28, 24) for communicative connection to the communication network (20) of the photovoltaic installation and for emitting the input device code to the communication network (20); and
the signalling apparatuses (32) are each designed to be activated via the communication network (20) upon receiving the device code of the respective component or the respective group of components in order to make the sought component or group of components (10, 12) detectable by observing the photovoltaic installation.

2. Photovoltaic installation according to Claim 1,
**characterized in that**
the components (10, 12) each have a control device (16) ; and
the communication interfaces (18) are provided on these control devices (16).

3. Photovoltaic installation according to Claim 1 or 2,
**characterized in that**
the components (10, 12) each have a control device (16); and
the signalling apparatuses (32) are connected to these control devices (16), the control devices (16) being designed to activate the at least one signalling apparatus (32) via the communication network (20) upon receiving the device code of the respective component or the respective group of components.

4. Photovoltaic installation according to one of the preceding claims,
**characterized in that**
the signalling apparatuses (32) are each provided with an energy storage apparatus which makes it possible to receive data via the communication network (20) and to operate the signalling apparatus(es) (32) at least for a certain period in the event of failure of the respective component(s).

5. Photovoltaic installation according to Claim 4,
**characterized in that**
the energy storage apparatuses are integrated in the respective control devices (16).

6. Photovoltaic installation according to one of the preceding claims,
**characterized in that**
the at least one signalling apparatus (32) of an individual component or a group of components (10, 12) is selected from acoustic signalling apparatuses, optical signalling apparatuses and combinations thereof.

7. Photovoltaic installation according to one of the preceding claims,
**characterized in that**
the at least one input apparatus (26, 30) is selected from mobile input apparatuses, input apparatuses connected to a component (10, 12) and input apparatuses connected to a central control device (22) of the photovoltaic installation.

8. Photovoltaic installation according to one of the preceding claims,
**characterized in that**
the communication network (20) of the photovoltaic installation is independent of the electricity connecting lines for the photovoltaically produced power.

9. Method for operating a photovoltaic installation having a plurality of electrical or electronic components (10, 12) at particular positions which are provided, individually or in groups, with at least one communication interface (18) which is communicatively connected to a communication network (20) of the photovoltaic installation,
in which, in order to find a sought component or group of components (10, 12):
a device code of the sought component or group of components is emitted to the communication network (20) of the photovoltaic installation via an input apparatus (26, 30); and
a signalling apparatus (32) on the component or group of components, which corresponds to the input device code, is activated via the communication network (20) of the photovoltaic installation upon receiving the input device code.

## Revendications

1. Installation photovoltaïque comportant une pluralité de composants électriques ou électroniques (10, 12) qui sont disposés à des positions déterminées, dans lequel les composants (10, 12) sont munis individuellement ou par groupes, d'au moins une interface de communication (18) qui est en liaison de communication avec un réseau de communication (20) de l'installation photovoltaïque,
**caractérisé en ce que** les composants (10, 12) comprennent respectivement, individuellement ou par groupes, au moins un dispositif de signalisation (32) qui est en liaison de communication, par l'intermédiaire d'une interface de communication (18), avec le réseau de communication (20) de l'installation photovoltaïque ;
l'installation photovoltaïque comprend au moins un dispositif d'entrée (26, 30) pour la fourniture en entrée d'un code d'appareil d'un composant individuel souhaité ou d'un groupe souhaité de la pluralité de composants (10, 12), qui est muni d'une interface de communication (28, 24) pour la liaison de communication avec le réseau de communication (20) de l'installation photovoltaïque et pour la transmission du code d'appareil fourni en entrée sur le réseau de communication (20) ; et
les dispositifs de signalisation (32) sont respectivement conçus pour être activés lors de la réception du code d'appareil du composant respectif ou du groupe respectif de composants par l'intermédiaire du réseau de communication (20) pour faire en sorte que le composant ou groupe de composants (10, 12) souhaité puisse être localisé en observant le système photovoltaïque.

2. Installation photovoltaïque selon la revendication 1, caractérisée en de que les composants (10, 12) comprennent respectivement un dispositif de commande (16) ; et
en ce que les interfaces de communication (18) sont prévues sur ces dispositifs de commande (16).

3. Installation photovoltaïque selon la revendication 1 ou 2, **caractérisée en ce que** les composants (10, 12) comprennent un dispositif de commande (16) respectif ; et
**en ce que** les dispositifs de signalisation (16) sont connectés auxdits dispositifs de commande (16), les dispositifs de commande (16) étant conçus pour activer, lors de la réception du code d'appareil du composant respectif ou du groupe de composants respectif, l'au moins un dispositif de signalisation (32) par l'intermédiaire du réseau de communication (20).

4. Installation photovoltaïque selon l'une quelconque des revendications précédentes, **caractérisée en ce que** les dispositifs de signalisation (32) sont respectivement munis d'un dispositif de stockage d'énergie qui, lors d'une panne du/des composant(s) respectif(s), permet la réception de données par l'intermédiaire du réseau de communication (20) et le fonctionnement du/des dispositif(s) de signalisation (32) pendant encore au moins une certaine période de temps.

5. Installation photovoltaïque selon la revendication 4, **caractérisée en ce que** les dispositifs de stockage d'énergie sont intégrés aux dispositifs de commande respectifs (16).

6. Installation photovoltaïque selon l'une quelconque des revendications précédentes, **caractérisée en ce que** l'au moins un dispositif de signalisation (32) d'un composant individuel ou d'un groupe de composants (10, 12) est sélectionné parmi des dispositifs de signalisation acoustiques, un dispositif de signalisation optique ou une combinaison de ceux-ci.

7. Installation photovoltaïque selon l'une quelconque des revendications précédentes, **caractérisée en ce que** l'au moins un dispositif d'entrée (26, 30) est sélectionné parmi des dispositifs d'entrée mobiles, des dispositifs d'entrée connectés à un composant (10, 12) et des dispositifs d'entrée connectés à une unité centrale de commande (22) de l'installation photovoltaïque.

8. Installation photovoltaïque selon l'une quelconque des revendications précédentes, **caractérisée en ce que** le réseau de communication (20) de l'installation photovoltaïque est indépendant des lignes de connexion de courant destinées à la puissance générée de manière photovoltaïque.

9. Procédé pour faire fonctionner une installation photovoltaïque comprenant une pluralité de composants électriques ou électroniques (10, 12) à des positions déterminées, munis, individuellement ou par groupes, d'au moins une interface de communication (18) qui est en liaison de communication avec un réseau (20) de l'installation photovoltaïque,
dans lequel, pour localiser un composant ou groupe de composants souhaité (10, 12) :
un code d'appareil du composant ou groupe de composants souhaité est émis par l'intermédiaire d'un dispositif d'entrée (26, 30) de l'installation photovoltaïque sur le réseau de communication (20) ; et
un dispositif de signalisation (32) du composant ou groupe de composants correspondant au code d'appareil fourni en entrée est activé lors de la réception du code d'appareil fourni en entrée par l'intermédiaire du réseau de communication (20) de l'installation photovoltaïque.
